# EUROPEAN PATENT SPECIFICATION

(11) **EP 2 371 997 B1**
(45) Date of publication and mention of the grant of the patent: **11.01.2017**
(21) Application number: 11159952.8
(22) Date of filing: 28.03.2011
(51) Int. Cl.: C30B 29/36, C30B 23/00, C30B 25/12

(54) **Method for manufacturing crystals of silicon carbide from gaseous phase**
Verfahren zur Herstellung von Siliciumcarbid Kristallen aus der gasförmigen Phase
Procédé de fabrication de cristaux de carbure de silicium à partir de la phase gazeuse

(30) Priority: 01.04.2010 PL 39089610
(43) Date of publication of application: 05.10.2011
(73) Proprietor: Instytut Technologii Materialów Elektronicznych, 01-919 Warszawa (PL)
(72) Inventor: Tymicki, Emil, 01-919 Warszawa (PL); Grasza, Krzysztof, 01-919 Warszawa (PL); Racka-Dzietko, Katarzyna, 01-919 Warszawa (PL)
(74) Representative: Sielewiesiuk, Jakub

(56) References cited:
- WO-A1-01/63020
- WO-A1-2009/026269
- JP-A- 2 030 699
- US-A1- 2002 083 892
- US-A1- 2002 088 391
- US-A1- 2006 107 890
- "Silicon Carbide and Related Materials 2009" In: "Silicon Carbide and Related Materials 2009", 1 April 2010 (2010-04-01), Trans tech Publication LTD, Switzerland-UK-USA, XP55004610, ISBN: 978-0-87-849279-4 pages x-xix, * page x * * page xi, lines 14-16 * & TYMICKI E ET AL: "Growth of 4H-SiC crystals on the 8[deg.] off-axis 6H-SiC seed by PVT method", MATERIALS SCIENCE FORUM, AEDERMANNSFDORF, CH, vol. 645-648, 1 April 2010 (2010-04-01), pages 17-20, XP008140239, ISSN: 0255-5476, DOI: 10.4028/WWW.SCIENTIFIC.NET/MSF.645-648.17 [retrieved on 2010-01-01]

## Description

### Technical Field

The invention relates to a method for manufacturing crystals, in particular of silicon carbide, from gaseous phase, said crystals being applicable in high power electronics and optoelectronics as substrate materials for epitaxial structures.

### Background

Known methods for obtaining silicon carbide crystals are based on application of monocrystalline seed in a form of thin wafer as the place for beginning the crystal growth.

A method employing such a seed is known from a public publication Y.M. Tairov, V.F.Tsvetkow, J.Crystal Growth, 43 (1978) 209. This method consist in heating silicon carbide SiC feedstock material in a form of polycrystalline powder above the temperature of 2000°C. At this temperature sublimation of SiC, i.e. vaporisation and decomposition into Si, Si₂, Si₂C, SiC₂ occurs, after which a process of crystallization proceeds on a monocrystalline seed, placed in the colder zone of the growth chamber. The process of crystallization lasts for 60-100 hours, a crystal obtained during that time has the length of 15-40mm.

Suitably crystallographically oriented surface of a monocrystalline wafer is prepared in a process of grinding, polishing and chemical, electrochemical and/or thermal etching. The thus prepared wafer is placed on a holder, to which it may adhere by its weight, being sucked in by sub-pressure or adhesive forces or it may be glued with substances binding to the wafer and to the holder used.

The common feature of known methods for mounting the seed to the holder is close matching of surfaces adhering to each other, described among others in the US patent number 7316747 B2. It consists in elimination of curvature of surfaces of the seed and the holder with a micrometer accuracy by polishing. To achieve this, a special geometry of polishing devices is used, which prevents the effect of rounding the surface during polishing. Another known method is filling the occurring gaps with a binder, such as carbon containing pastes. Binders used for this purpose must be resistant to high temperature, which in a technological process reaches 2400°C. Despite adhering, the binders must also tightly fill the gap occurring between the seed and the holder, on which the seed is placed. It is not fully possible, because all available binders decrease their volume during annealing. The occurring vacancies are the reason for bad crystalline quality of crystals, due to the phenomenon of migration of vacancies to the volume of the crystal. Microscopic smoothness of the holder, to which the seed is mounted, also influences the overall technological process. As the high temperature forces application of graphite or products based on graphite, such as graphite glass or metals having high melting temperature, a perfect smoothness of the surface of the holder is obtained by using graphite having a high density, so - having low porosity coefficient, and its mechanical treatment. In case a low density graphite, having a high porosity coefficient, is used, the obtained surface of the holder, even if prepared with utmost precision, is by its nature a rough surface.

In the technology of manufacturing of silicon carbide crystals, devices are used, whose interior - that is: the place of crystallization - is not accessible during the crystallization process. Everything is surrounded by a steel layer, covered with a water coating, which isolates heated elements from the outside surroundings. Controlling and temperature measurements are only possible in two points . The growing crystal is not being observed. Observation is only possible in the indirect way by X-raying the system, as described in the publication P.J. Wellman et al, J. Crystal Growth 216 (2000) 263. Therefore all phenomena related to incorrect mounting of the seed are only recognized after the crystallization process is finished. Because of that, the crystal growth process is often continued for many days without a chance for success. The obtained crystals are often not suitable for application in another step of technological process. Neither can they be used for manufacturing seeds, with which next crystals dedicated for seeds and restoring technological potential are produced.

Tymicki E at al, "Growth of 4H-SiC crystals on the 8[deg.] off-axis 6H-SiC seed by PVT method", Materials ScienceForum, Aedermannsfdorf, CH, vol. 645-648, discloses a method for manufacturing crystals of silicon carbide from gaseous phase by heating a monocrystalline seed in a form of a wafer up to the temperature of crystallization in a graphite growth chamber filled with an inert gas or with a gas ensuring doping of the crystal. On the bottom of chamber a feedstock is placed. Said monocrystalline seed. in a form of a wafer, is mounted in a ring of a high purity graphite such that only its edge abuts directly with the ring. The seed is placed in the upper part of the growth chamber filled with an inert gas or with a gas ensuring doping of the crystal, with the feedstock deposited on its bottom. Then the seed is heated up to the crystallization temperature at the condition of a high pressure of the gas filling the chamber. A higher temperature in the lower part of the chamber is maintained while preserving the temperature difference between the feedstock and the seed in the range from 50°C to 300°C and preferably parabolic character of the axial temperature profile. Adding cerium in the form of CeO2 to the growth environment, by placing it in a crucible inside the growth chamber, is also disclosed.

### Summary

The method according to the invention is a method for manufacturing crystals of silicon carbide from gaseous phase by heating a monocrystalline seed in a form of a wafer up to the temperature of crystallization in a graphite growth chamber filled with an inert gas or with a gas ensuring doping of the crystal, on the bottom of which chamber a feedstock is placed, wherein said monocrystalline seed in a form of a wafer, mounted in a ring made of high purity graphite in such way that only its edge abuts directly with the ring, is placed in the upper part of a growth chamber, filled with an inert gas or a gas ensuring doping of the crystal, with a feedstock placed on its bottom, after which the seed is heated up to the crystallization temperature under the condition of a high pressure of the gas filling the chamber, and a higher temperature in the lower part of the chamber is maintained, while preserving temperature difference between the feedstock and seed in the range from 50°C to 300°C and preferably parabolic character of the axial temperature profile, characterized in that a cerium-containing compound is added to the environment of the growth process, said cerium-containing compound being placed outside the growth chamber, in the vicinity of the seed.

With such mounting of the seed, preferably a seed wafer is used having only one front surface polished.

Preferably, the seed wafer is placed with its edge on a ring-shaped protrusion, being integrally formed with the ring, while the ring and the seed wafer is deposited on a protrusion of a side wall of the growth chamber. If needed, the edge of the seed is additionally sealed with a graphite paste or a silicon carbide paste.

With such arrangement of the seed, the back surface of the seed (i.e. the surface of the seed directed away from the growth chamber) is essentially uncovered ("free"). As the result, no defects caused by e.g. incorrect gluing or coating of the back surface of the seed are introduced into the obtained crystal. Therefore, a higher crystalline quality is achieved.

Usually the seed oriented in the plane (0001) is used, being crystallographically oriented along the direction parallel to crystallographic axis c, however it is also possible to use seeds of other crystallographic orientations.

The seed wafer used preferably has a thickness from 0.2mm to 3mm.

As the seed, preferably a wafer of silicon carbide is used, most preferably a wafer whose front surface has carbon or silicon polarity.

As the feedstock, preferably silicon carbide is used, which - depending on the desired properties of the obtained crystal - is used undoped or enriched with dopants, such as boron, vanadium, aluminium, iron and/or redundant non-stoichiometric silicon.

In order to obtain crystal doped with nitrogen, silicon carbide as a feedstock is placed in a growth chamber filled with nitrogen or a nitrogen-containing inert gas.

As a gas filling the growth chamber, usually argon, nitrogen, hydrogen and/or helium is used.

The seed is heated up preferably to the temperature from 1900°C to 2400°C, on its back surface.

The process is conducted with a use of a temperature field and a field of partial pressures of vapours, out of which a crystal is formed, which fields are adjusted to crystal growth rates in the range from 0.01 mm/h to 2mm/h.

Silicon carbide forms crystals, which are polar along their main crystallographic axis c. It means that two planes perpendicular to said c axis may be distinguished, called C-terminated plane (also: carbon plane, plane having carbon polarity) and Si-terminated side (also: silicon plane, plane having silicon polarity). The C-terminated plane is terminated with C atoms, while the S-terminated plane is terminated with Si atoms. These planes (surfaces of a crystal) have different physical and chemical properties. Crystal of the 4H-SiC polytype are obtained on the C-terminated surface of a monocrystalline seed, while crystals of the 6H-SiC polytype may be obtained on both C-terminated surface or Si-terminated surface of a monocrystalline seed. However, their growth on the Si-terminated surface is more stable.

As explained above, the growth process according to the present invention is conducted with the back surface of the seed being uncovered. If the growth process is conducted on the Si-terminated surface of the seed - the other surface, being the C-terminated surface of the seed, is uncovered and vice versa. At process conditions, such an uncovered surface is subject to carbonization. The rate of carbonization depends on exact thermodynamical conditions of the growth process (in particular: on temperature and pressure). It is higher for the surface having carbon polarity and ranges from 0.01 mm/h to 0.15mm/h. For the surface having silicon polarity, the carbonization rate in approximately a few times lower. As the result of carbonization, a remarkable part of the obtained crystal may be lost.

An addition of cerium to the environment of the growth process remarkably (even by an order of magnitude) decreases the carbonization rate of the back surface of the seed, especially if that back surface has carbon polarity, comparing to a process in which cerium is not added. Most probably, cerium reacts with silicon atoms, producing a tight layer of graphite on the seed, which prevents sublimation of consecutive atomic layers of the seed (and the obtained crystal). Cerium may be introduced in any form - as elemental cerium or in a form of chemical compounds, such as CeO₂, Ce₂O₃, CeSi₂, CeC₂ etc.

Therefore, according to the invention cerium is added to the environment of the growth process and placed outside the growth chamber, but still in the vicinity of the monocrystalline seed. The arrangement outside the growth chamber does not influence the growth rate and the properties of the obtained crystal. It is particularly preferable to place cerium or a cerium-containing compound in a groove made in the graphite ring, used to seal the edges of the seed wafer.

Preparation of a seed to the inventive crystallization process is limited to polishing only one front surface of the seed wafer, without the need to maintain flatness of the polished surface, which saves a lot of time comparing to known methods.

The method according to the invention enables crystal growth rates many times higher than the rate of sublimation of the back surface of the seed and prevents rapid sublimation before the crystallization is started, while the shape and morphology of the crystallization front enables creation of a high quality crystal.

The inventive method ensures a high reproducibility of the process as well as controlled doping, enabling manufacturing of crystals having a wide range of electrical properties. It also enables application of a non-conventional crystallization direction and using for crystallization different polytypes of silicon carbide, as well as other materials, such as for example AlN and ZnO.

### Brief Description of the Drawings

Preferred embodiments of the present invention are described below in a more detailed way with reference to the attached drawing, in which:
Fig. 1 presents an example of a system for manufacturing crystals from gaseous phase, by the method according to the present invention, as described in examples 1 to 9;
fig. 2 presents a detailed view of the seed and the obtained crystal after the growth process, wherein the seed and part of the obtained crystal is carbonised, as described in examples 1 to 9;
fig. 3 presents another example of a system for manufacturing crystals from gaseous phase, by the method according to the present invention, as described in example 12;
fig. 4 presents a detailed view of the seed and the obtained crystal after the growth process, wherein only the surface of the seed is carbonised as described in examples 10 and 11 and
fig. 5 presents a detailed view of the seed and the obtained crystal after the growth process, wherein only the surface of the seed is carbonised as described in example 12.

### Detailed Description

The examples described below illustrate the inventive method in specific, preferable embodiments.

### Example 1

A monocrystalline seed 1 of silicon carbide, having the orientation (0001), in a form of a 6H-SiC wafer, having a thickness of 1 mm and having only its carbon surface polished before the process, was mounted in a ring 3 of a high purity graphite, such that the wafer was placed with its edge on a ring-shaped protrusion 7, being integrally formed with the ring 3, and sealed with a graphite ring 9. The ring 3 with the seed wafer 1 was placed in the upper part of a growth chamber 6, by placing it on a protrusion 8 of the side wall of a chamber 6 and limiting it from above with a graphite isolation 4. On the bottom of the chamber 6, a feedstock 5 (also called SiC source material) in a form of a silicon carbide powder was deposited.

The seed wafer 1 was directed with its front surface (0001), having carbon polarity, towards the feedstock 5, while its back surface - was directed towards the colder part of the chamber 6. Both the front and back surface of the seed wafer 1, not covered with graphite elements, are subject to a sublimation process and the front surface is also subject to a process of deposition of a material diffusing from the feedstock 5.

The empty space of the growth chamber 6 was filled with pure argon at a pressure of 20 mbar.

The seed 1 was heated up to the temperature of 2200°C, measured with pyrometers on its back side, and adjusting temperature to consecutive steps of growth of the crystal 2.

The lower part of the chamber 6 with the feedstock 5 was heated up to the temperature of 2400°C, also adjusting the temperature to consecutive steps of growth of the crystal 2.

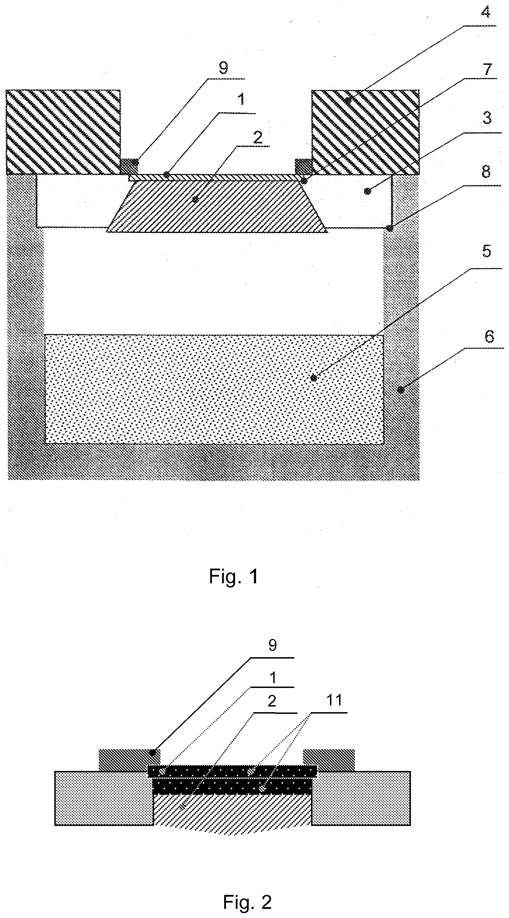

After 75h of crystallization, an 6H-SiC crystal 2 was obtained, having n-type electrical conductivity and having n-type carrier concentration of 3x10¹⁷cm⁻³. The 6H-SiC crystal growth rate was 0.4mm/h. As shown in fig. 2, a layer 11 (approximately 2.5mm thick) of the seed 1 became carbonised during the process.

### Example 2

A monocrystalline seed 1 of silicon carbide, having the orientation (0001), in a form of a 4H-SiC wafer, having a thickness of 1mm, prepared as in example 1, was mounted in the ring 3, as in example 1. The ring 3 together with the seed wafer 1 was placed in the upper part of the growth chamber 6, as in example 1. A feedstock 5, in a form of a pre-crystallized silicon carbide, was placed on the bottom of the growth chamber 6. The chamber 6 was filled with a mixture of argon and nitrogen in the ratio of 80:20, at a pressure of 60mbar, adjusted to crystallization temperature. The crystallization process was conducted at temperatures as in example 1.

After 75h of crystallization, an 4H-SiC crystal 2 was obtained, having n-type electrical conductivity and having n-type carrier concentration of 1x10¹⁹cm⁻³. The 4H-SiC crystal growth rate was 0.2 mm/h. As shown in fig. 2, a layer 11 (approximately 1.5mm thick) of the seed 1 became carbonised during the process.

### Example 3

A monocrystalline seed 1 of silicon carbide, having the orientation (0001), in a form of a 4H-SiC wafer, having a thickness of 1mm, prepared as in example 1, was mounted in the ring 3 and placed in the chamber 6, as in example 1. On the bottom of the growth chamber 6, a feedstock 5 was placed in a form of a silicon carbide powder. As the growth atmosphere, a mixture of argon and nitrogen in the ratio of 90:10, at a pressure of 20mbar was used. The temperature measured on the crystal was 2200°C, and on the feedstock was 2400°C.

After 75h of crystallization, an 4H-SiC crystal 2 was obtained, having n-type electrical conductivity and having n-type carrier concentration of 4x10¹⁸cm⁻³. The 4H-SiC crystal growth rate was 0.4mm/h. As shown in fig. 2, a layer 11 (approximately 2.5mm thick) of the seed 1 became carbonised during the process.

### Example 4

A monocrystalline seed 1 of silicon carbide, having the orientation (0001), in a form of a 4H-SiC wafer, having the thickness of 1 mm, prepared as in example 1, was mounted in the ring 3 and placed in the chamber 6, as in example 1. On the bottom of the growth chamber 6,a feedstock 5 was placed in a form of a silicon carbide powder. As the growth atmosphere, pure nitrogen at a pressure of 50mbar was used. The temperature measured on the crystal was 2100°C, and on the feedstock was 2200°C.

After 75h of crystallization, an 4H-SiC crystal 2 was obtained, having n-type electrical conductivity and having n-type carrier concentration of 8x10¹⁹cm⁻³. The 4H-SiC crystal growth rate was 0.05mm/h. As shown in fig. 2, a layer 11 (approximately 0.8mm thick) of the seed 1 became carbonised during the process.

### Example 5

A monocrystalline seed 1 of silicon carbide, having the orientation tilted off by 8° from the crystalline axis c, in a form of a 6H-SiC wafer, having a thickness of 0.5mm, prepared as in example 1, was mounted in the ring 3 and placed in the chamber 6, as in example 1. On the bottom of the growth chamber 6, a feedstock 5 was placed in a form of a silicon carbide powder with boron as a dopant. As the growth atmosphere, pure argon at a pressure of 60mbar was used. The temperature measured on the crystal was 2150°C, and on the feedstock was 2250°C.

After 75h of crystallization, an 6H-SiC crystal 2 was obtained, having p-type electrical conductivity and having p-type carrier concentration of 2x10¹⁴cm⁻³. The 6H-SiC crystal growth rate was 0.13mm/h. As shown in fig. 2, a layer 11 (approximately 1mm thick) of the seed 1 became carbonised during the process.

### Example 6

A monocrystalline seed 1 of silicon carbide, having the orientation tilted off by 4° from the crystalline axis c, in a form of a 6H-SiC wafer, having a thickness of 1 mm, prepared as in example 1, was mounted in the ring 3 and placed in the chamber 6, as in example 1. On the bottom of the growth chamber 6, a feedstock 5 was placed in a form of a silicon carbide powder with aluminium as a dopant. As the growth atmosphere, argon at a pressure of 80mbar was used. The temperature measured on the crystal was 2100°C, and on the feedstock was 2200°C.

After 75h of crystallization, an 6H-SiC crystal 2 was obtained, having p-type electrical conductivity and having p-type carrier concentration of 2x10¹⁷cm⁻³. The 6H-SiC crystal growth rate was 0.02mm/h. As shown in fig. 2, a layer 11 (approximately 0.5mm thick) of the seed 1 became carbonised during the process.

### Example 7

A monocrystalline seed 1 of silicon carbide, having the orientation tilted off by 2° from the crystalline axis c, in a form of a 6H-SiC wafer, having a thickness of 3mm, prepared as in example 1, was mounted in the ring 3 and placed in the chamber 6, as in example 1. On the bottom of the growth chamber 6, a feedstock 5 was placed in a form of a silicon carbide powder with vanadium as a dopant. As the growth atmosphere, a high purity argon at a pressure of 10mbarwas used. The temperature measured on the crystal was 2150°C, and on the feedstock was 2400°C.

After 75h of crystallization, an 6H-SiC crystal 2 was obtained, having increased electrical resistivity of 1000Ω/cm. The 6H-SiC crystal growth rate was 0.7mm/h. As shown in fig. 2, a layer 11 (approximately 3mm thick) of the seed 1 became carbonised during the process.

### Example 8

Procedure as described in example 1 was repeated, however, the 6H-SiC seed 1 wafer having only its silicon surface polished before the process. The seed wafer 1 was directed with its front surface (0001), having silicon polarity, towards the feedstock.

After 75h of crystallization, an 6H-SiC crystal 2 was obtained, having n-type electrical conductivity and having n-type carrier concentration of 2x10¹⁷cm⁻³. The 6H-SiC crystal growth rate was 0.4mm/h. As shown in fig. 2, a layer 11 (approximately 8mm thick) of the seed 1 became carbonised during the process.

### Example 9

Procedure as described in example 8 was repeated, however, as the growth atmosphere, a pressure of 60mbar was used. The temperature measured on the crystal was 2100°C, and on the feedstock was 2200°C.

The 6H-SiC seed 1 wafer having only its silicon surface polished before the process. The seed wafer 1 was directed with its front surface (0001), having silicon polarity, towards the feedstock

After 75h of crystallization, an 6H-SiC crystal 2 was obtained, having n-type electrical conductivity and having n-type carrier concentration of 2x10¹⁷cm⁻³. The 6H-SiC crystal growth rate was 0.05mm/h. As shown in fig. 2, a layer 11 (approximately 3mm thick) of the seed 1 became carbonised during the process.

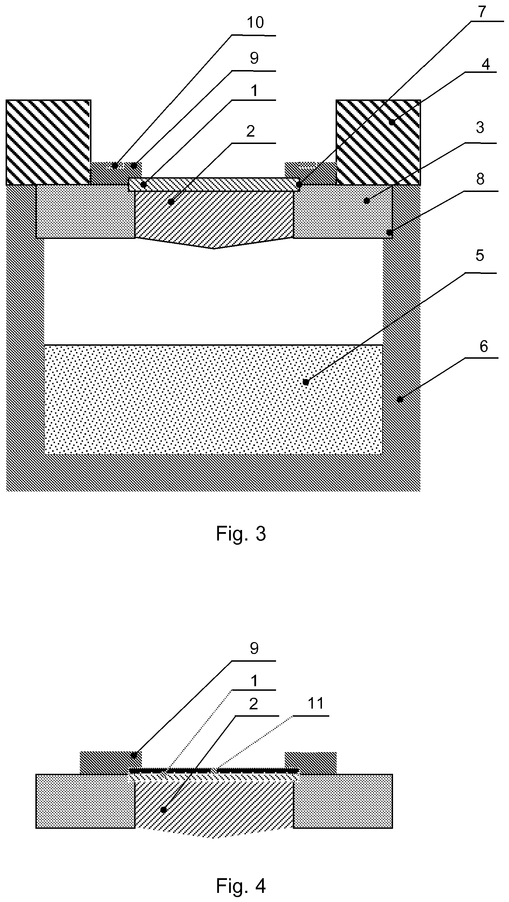

In all the aforementioned embodiments described in examples 1 to 9, the seed 1 used, as well as a part 11 of the obtained crystal 2, was lost due to undesired carbonization, as can be seen in fig. 2, which presents a detailed view of the seed 1 and the obtained crystal 2 after such a growth process (carbonised part 11 is marked in dark colour, it may be even 8 mm thick). To prevent this, another process was conducted using a modified system, shown schematically in fig. 3. This system is very similar to that in fig. 1, however, the graphite ring 9 comprises a groove 10, in which a cerium-containing compound may be placed or SiC source material was doped cerium compounds.

### Example 10

Procedure as described in example 1 was repeated, however, 0.5g of CeO₂ was placed in the feedstock 5.

After 75h of crystallization, an 4H-SiC crystal 2 was obtained, having n-type electrical conductivity and having n-type carrier concentration of 3x10¹⁷cm⁻³. The 4H-SiC crystal growth rate was 0.4mm/h. As shown in fig. 4, a layer 11 (approximately 0.6mm thick) of the seed 1 became carbonised during the process.

### Example 11

Procedure as described in example 8 was repeated, however, the 6H-SiC seed 1 wafer having only its silicon surface polished before the process. The seed wafer 1 was directed with its front surface (0001), having silicon polarity, towards the feedstock 5. Moreover, 1 g of CeSi₂ was placed in the feedstock 5.

After 75h of crystallization, an 6H-SiC crystal 2 was obtained, having n-type electrical conductivity and having n-type carrier concentration of 2x10¹⁷cm⁻³. The 6H-SiC crystal growth rate was 0.4mm/h. As shown in fig. 4, only a thin layer 11 (approximately 0.2mm thick) of the seed 1 became carbonised during the process.

### Example 12

Procedure as described in example 8 was repeated, however, the 6H-SiC seed 1 wafer having only its silicon surface polished before the process. The seed wafer 1 was directed with its front surface (0001), having silicon polarity, towards the feedstock 5. Moreover, 0.3g of CeO₂ was placed in the groove 10 in the graphite ring 9 used to seal the edges of the seed wafer 1.

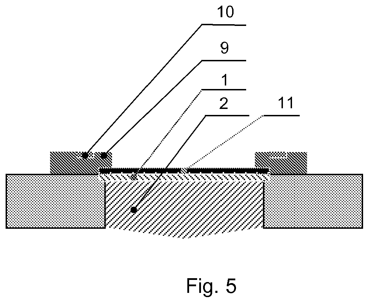

After 75h of crystallization, an 6H-SiC crystal 2 was obtained, having n-type electrical conductivity and having n-type carrier concentration of 2x10¹⁷cm⁻³. The 6H-SiC crystal growth rate was 0.4mm/h. As shown in fig. 5, only a thin layer 11 (approximately 0.2mm thick) of the seed 1 became carbonised during the process.

Similar experiments as described in example 10 to 12 were performed, using other cerium-containing compounds, in particular: Ce₂O₃, CeSi₂, CeC₂ as well as elemental cerium. The cerium-containing compounds were added in the amount ranging from 0.1 g to 10g, preferably about 0.3g (or: in the weight ratio with respect to the feedstock 5 ranging from 0.01% to 1%, preferably about 0.03% - since usually the amount of feedstock 5 was 1000g). Similar favourable effect of preventing the undesired carbonisation of the seed 1 wand the obtained crystal 2 was observed in all such experiments.

## Claims

1. A method for manufacturing crystals of silicon carbide from gaseous phase by heating a monocrystalline seed in a form of a wafer up to the temperature of crystallization in a graphite growth chamber filled with an inert gas or with a gas ensuring doping of the crystal, on the bottom of which chamber a feedstock is placed,
wherein said monocrystalline seed (1) in a form of a wafer, mounted in a ring (3) of a high purity graphite such that only its edge abuts directly with the ring (3), the seed (1) is placed in the upper part of the growth chamber (6) filled with an inert gas or with a gas ensuring doping of the crystal, with the feedstock (5) deposited on its bottom, after which the seed (1) is heated up to the crystallization temperature at the condition of a high pressure of the gas filling the chamber (6) and a higher temperature in the lower part of the chamber (6) is maintained while preserving the temperature difference between the feedstock (5) and the seed (1) in the range from 50°C to 300°C and preferably parabolic character of the axial temperature profile,
**characterized in that** a cerium-containing compound is added to the environment of the growth process, said cerium-containing compound being placed outside the growth chamber (6), in the vicinity of the seed (1).

2. The method according to claim 1, **characterized in that** said cerium-containing compound being placed in a groove (10), made in a ring (9) used to seal the edges of the seed wafer (1).

3. The method according to claim 1 or 2, **characterized in that** a seed (1) in a form of a wafer having only one front surface polished is used.

4. The method according to any of claims 1 to 3, **characterized in that** a seed (1) in a form of a wafer deposited with its edge on a ring-shaped protrusion (7) being integrally formed with the ring (3) is used.

5. The method according to any of the preceding claims, **characterized in that** the ring (3) together with the seed wafer (1) is deposited on a protrusion (8) of the side wall of the growth chamber (6).

6. The method according to any of the preceding claims, **characterized in that** a seed (1) crystallographically oriented along the direction parallel to the crystalline axis c is used.

7. The method according to any of the preceding claims, **characterized in that** a seed (1) in a form of a wafer having a thickness from 0.2mm to 3mm is used.

8. The method according to any of the preceding claims, **characterized in that** as the seed (1), a wafer of silicon carbide is used, which wafer of silicone carbide preferably has the front surface of carbon polarity or of silicon polarity.

9. The method according to any of the preceding claims, **characterized in that** silicon carbide, preferably doped with boron, vanadium, aluminium or a mixture thereof is used as the feedstock (5).

10. The method according to claim 9, **characterized in that** silicon carbide having non-stoichiometric composition and comprising redundant silicon is used as the feedstock (5).

11. The method according to claim 9, **characterized in that** silicon carbide used as the feedstock (5) is placed in the growth chamber (6), filled with nitrogen or with a nitrogen-containing inert gas.

12. The method according to any of the preceding claims, **characterized in that** the seed (1) is heated up to the temperature from 1900°C to 2400°C on its back surface.

13. The method according to any of the preceding claims, **characterized in that** the process is carried out using a temperature field and a field of partial pressures of vapours, out of which the crystal is created, adjusted to growth rates of the crystal (2) in the range from 0.01 mm/h to 2 mm/h.

14. The method according to any of the preceding claims, **characterized in that** said cerium-containing compound is selected from the group comprising CeO₂, Ce₂O₃, CeSi₂, CeC₂, elemental cerium and mixtures thereof.

15. The method according to any of the preceding claims, **characterized in that** said cerium-containing compound is added in the amount of 0.1 g to 10g, preferably about 0.3g or in the weight ratio of 0.01% to 1%, preferably about 0.03%, with respect to the feedstock (5).

## Patentansprüche

1. Verfahren zur Herstellung von Kristallen aus Siliciumcarbid aus der Gasphase durch Erhitzen eines einkristallinen Keims in Form einer Scheibe bis zur Kristallisationstemperatur in einer Graphitwachstumskammer mit einem Inertgas oder mit einem Gas, das die Dotierung des Kristalls gewährleistet, dessen Boden der Kammer ein Einsatzmaterial angeordnet ist,
wobei der einkristalline Keim (1) in Form einer Scheibe, die in einem hochreinen Graphitring (3) montiert ist, so dass nur seine Kante direkt mit dem Ring grenzen (3), der Keim (1) im oberen Teil der mit einem Inertgas oder mit einem die Dotierung des Kristalls gewährleistenden Gas gefüllten Aufwachskammer (6) angeordnet ist, wobei das Einsatzmaterial (5) an seinem Boden abgelagert ist, wonach der Keim (1) auf die Kristallisationstemperatur im Zustand eines hohen Drucks der Gasfüllung der Kammer (6) erwärmt wird und eine höhere Temperatur im unteren Teil der Kammer (6) gehalten wird, während die Temperaturdifferenz zwischen dem Einsatzmaterial (5) und dem Keim (1) im Bereich von 50°C bis 300°C und vorzugsweise parabolischer Charakter des axialen Temperaturprofils erhalten wird,
**dadurch gekennzeichnet, dass** der Umgebung des Wachstumsprozesses eine cerhaltige Verbindung zugesetzt wird, wobei die genannte cerhaltige Verbindung außerhalb der Wachstumskammer (6) in der Nähe des Keims (1) angeordnet ist.

2. Verfahren nach Anspruch 1, **dadurch gekennzeichnet, dass** die cerhaltige Verbindung in einer Rille (10) angeordnet ist, die in einem Ring (9), der zum Abdichten der Kanten der Keimscheibe (1) dient, hergestellt ist.

3. Verfahren nach Anspruch 1 oder 2, **dadurch gekennzeichnet, dass** der Keim (1) in Form einer Scheibe mit nur einer Vorderseite poliert verwendet wird.

4. Verfahren nach einem der Ansprüche 1 bis 3, **dadurch gekennzeichnet, dass** ein Keim (1) in Form einer mit seinem Kant auf einem ringförmigen Vorsprung (7) abgelagerten Scheibe mit dem integral ausgebildetem Ring (3) verwendet wird.

5. Verfahren nach einem der vorhergehenden Ansprüche, **dadurch gekennzeichnet, dass** der Ring (3) zusammen mit der Keimscheibe (1) auf einem Vorsprung (8) der Seitenwand der Wachstumskammer (6) abgelagert wird.

6. Verfahren nach einem der vorhergehenden Ansprüche, **dadurch gekennzeichnet, dass** ein Keim (1), der kristallographisch entlang der Richtung parallel zur kristallinen Achse c orientiert ist, verwendet wird.

7. Verfahren nach einem der vorhergehenden Ansprüche, **dadurch gekennzeichnet, dass** der Keim (1) in Form einer Scheibe mit der Dicke von 0,2mm bis 3mm verwendet wird.

8. Verfahren nach einem der vorhergehenden Ansprüche, **dadurch gekennzeichnet, dass** als Keim (1) eine Scheibe aus Siliciumcarbid verwendet wird, wobei die Scheibe aus Siliciumcarbid vorzugsweise die Vorderseite mit der Kohlenstoffpolarität oder der Siliziumpolarität aufweist.

9. Verfahren nach einem der vorhergehenden Ansprüche, **dadurch gekennzeichnet, dass** als Einsatzmaterial (5) Siliciumcarbid, vorzugsweise mit Bor, Vanadium, Aluminium oder ein Gemisch davon dotiert verwendet wird.

10. Verfahren nach Anspruch 9, **dadurch gekennzeichnet, dass** als Einsatzmaterial (5) ein mit nichtstöchiometrischer Zusammensetzung und redundantem Silicium enthaltendes Siliciumcarbid verwendet wird.

11. Verfahren nach Anspruch 9, **dadurch gekennzeichnet, dass** als Einsatzmaterial (5) verwendetes Siliciumcarbid in der mit Stickstoff oder einem stickstoffhaltigen Inertgas gefüllten Wachstumskammer (6) angeordnet wird.

12. Verfahren nach einem der vorhergehenden Ansprüche, **dadurch gekennzeichnet, dass** der Keim (1) auf die Temperatur von 1900°C bis 2400°C auf seiner Rückseite erhitzt wird.

13. Verfahren nach einem der vorhergehenden Ansprüche, **dadurch gekennzeichnet, dass** das Verfahren unter Verwendung eines Temperaturfeldes und eines Feldes von Partialdrücken von Dämpfen, aus denen der Kristall erzeugt wird, auf die in der Bereich von 0,01 mm/h bis 2 mm/h eingestellten Wachstumsraten des Kristalls (2) durchgeführt wird.

14. Das Verfahren nach einem der vorhergehenden Ansprüche, **dadurch gekennzeichnet, dass** das cerhaltige Verbindung aus der Gruppe bestehend aus CeO₂, Ce₂O₃, CeSi₂, CeC₂ elementares Cer und deren Gemische ausgewählt ist.

15. Das Verfahren nach einem der vorhergehenden Ansprüche, **dadurch gekennzeichnet, dass** das cerhaltige Verbindung in einer Menge von 0,1 g bis 10 g, vorzugsweise ca. 0,3 g oder im Gewichtsverhältnis von 0,01% bis 1%, vorzugsweise ca. 0,03% in Bezug auf das Einsatzmaterial (5) zugesetzt wird.

## Revendications

1. Une méthode de fabrication de cristaux de carbure de silicium à partir d'une phase gazeuse par chauffage d'une graine monocristalline sous forme d'une tranche jusqu'à la température de cristallisation dans une chambre de croissance de graphite remplie d'un gaz inerte ou d'un gaz assurant le dopage du cristal, sur le fond de ladite chambre une charge d'alimentation étant placée,
dans laquelle ladite graine monocristalline (1) sous forme d'une tranche, monté dans un anneau (3) de graphite de haute pureté de sorte que seul son bord vient en butée directement avec l'anneau (3), la graine (1) est placée dans la partie supérieure de la chambre de croissance (6) remplie d'un gaz inerte ou d'un gaz assurant le dopage du cristal, avec la charge d'alimentation (5) déposée sur son fond, après quoi la graine (1) est chauffée jusqu'à la température de cristallisation à la condition d'une pression élevée du gaz remplissant la chambre (6) et une température plus élevée dans la partie inférieure de la chambre (6) est maintenue tout en préservant la différence de température entre la charge d'alimentation (5) et la graine (1) dans la plage de 50°C à 300°C et de préférence le caractère parabolique du profil de température axiale,
**caractérisée en ce qu**'un composé contenant du cérium est ajouté à l'environnement du procédé de croissance, ledit composé contenant du cérium étant placé à l'extérieur de la chambre de croissance (6), à proximité de la graine (1).

2. La méthode selon la revendication 1, **caractérisée en ce que** ledit composé contenant du cérium étant placé dans une rainure (10), faite dans un anneau (9) utilisé pour sceller les bords de la tranche de graine (1).

3. La méthode selon la revendication 1 ou 2, **caractérisée en ce qu**'une graine (1) sous forme d'une tranche ayant une seule surface frontale polie est utilisée.

4. La méthode selon l'une quelconque des revendications 1 à 3, **caractérisée en ce qu**'une graine (1) sous forme d'une tranche déposée avec son bord sur une saillie en forme d'anneau (7) étant intégralement formé avec l'anneau (3) est utilisée.

5. La méthode selon l'une quelconque des revendications précédentes, **caractérisée en ce que** l'anneau (3) ensemble avec la tranche de graine (1) est déposé sur une saillie (8) de la paroi latérale de la chambre de croissance (6).

6. La méthode selon l'une quelconque des revendications précédentes, **caractérisée en ce qu**'une graine (1) cristallographiquement orienté le long de la direction parallèle à l'axe cristallin c est utilisée.

7. La méthode selon l'une quelconque des revendications précédentes, **caractérisée en ce qu**'une graine (1) sous forme d'une tranche ayant une épaisseur de 0,2 mm à 3 mm est utilisée.

8. La méthode selon l'une quelconque des revendications précédentes, **caractérisée en ce que** comme la graine (1), une tranche de carbure de silicium est utilisée, laquelle tranche de carbure de silicium présente de préférence la surface frontale de la polarité de carbone ou de la polarité de silicium.

9. La méthode selon l'une quelconque des revendications précédentes, **caractérisée en ce que** le carbure de silicium, de préférence dopé par du bore, du vanadium, de l'aluminium ou un mélange de ceux-ci est utilisé comme la charge d'alimentation (5).

10. La méthode selon la revendication 9, **caractérisée en ce que** le carbure de silicium ayant une composition non stoechiométrique et comprenant du silicium redondant est utilisé comme la charge d'alimentation (5).

11. La méthode selon la revendication 9, **caractérisée en ce que** le carbure de silicium utilisé comme la charge d'alimentation (5) est placé dans la chambre de croissance (6), remplie d'azote ou d'un gaz inerte contenant de l'azote.

12. La méthode selon l'une quelconque des revendications précédentes, **caractérisée en ce que** la graine (1) est chauffée jusqu'à la température de 1900°C à 2400°C sur sa surface arrière.

13. La méthode selon l'une quelconque des revendications précédentes, **caractérisée en ce que** le processus est mis en oeuvre en utilisant un champ de température et un champ de pressions partielles de vapeurs, à partir desquels le cristal est créé, ajustés aux taux de croissance du cristal (2) dans la plage de 0,01 mm/h à 2 mm/h.

14. La méthode selon l'une quelconque des revendications précédentes, **caractérisée en ce que** ledit composé contenant du cérium est choisi dans le groupe comprenant CeO₂, Ce₂O₃, CeSi₂, CeC₂, le cérium élémentaire et des mélanges de ceux-ci.

15. La méthode selon l'une quelconque des revendications précédentes, **caractérisée en ce que** ledit composé contenant du cérium est ajouté en une quantité de 0,1 g à 10 g, de préférence d'environ 0,3 g ou dans le rapport en poids de 0,01% à 1%, de préférence d'environ 0,03%, par rapport à la charge d'alimentation (5).
